# EUROPEAN PATENT APPLICATION

(11) **EP 4 650 978 A1**
(43) Date of publication of application: **19.11.2025**
(21) Application number: 24741206.7
(22) Date of filing: 08.01.2024
(51) Int. Cl.: G06F 16/22

(54) **DATA PROCESSING METHOD AND APPARATUS, AND MEDIUM AND COMPUTER DEVICE**

(30) Priority: 09.01.2023 CN 202310029941
(71) Applicant: Cloud Intelligence Assets Holding (Singapore) Private Limited, Singapore 189554 (SG)
(72) Inventor: ZHANG, David, Sunnyvale, CA 94085 (US); MA, Zhanfeng, Hangzhou, Zhejiang 310030 (CN); YANG, Xinjun, Hangzhou, Zhejiang 310030 (CN); LI, Feifei, Hangzhou, Zhejiang 310030 (CN)
(74) Representative: Barker Brettell LLP
(86) International application number: PCT/CN2024/071228
(87) International publication number: WO 2024/149207

(57) **Abstract**

A data processing method and apparatus, a medium, and a computer device are provided. The method includes: obtaining target compression columns of a plurality of user records on a first data page, where the target compression columns include data of a numeric type; determining a first base value corresponding to each target compression column, where the first base value corresponding to the target compression column is used for base-delta encoding of the target compression columns of respective user records on the first data page; and generating a first base value record based on first base values corresponding to respective target compression columns, and storing the first base value record into the first data page.

## Description

This application claims priority to Chinese Patent Application No. 202310029941.7, entitled "DATA PROCESSING METHOD AND APPARATUS, MEDIUM, AND COMPUTER DEVICE" filed with the China National Intellectual Property Administration on January 09, 2023, which is incorporated by reference in its entirety.

### TECHNICAL FIELD

The present disclosure relates to the field of data processing technologies, and in particular, to a data processing method and apparatus, a medium, and a computer device.

### BACKGROUND

A database generally uses a data page as a smallest storage unit. To reduce storage overheads and improve performance of a data system, data pages are usually compressed. Generally, a data compression method commonly used in the related art is to remove high-order 0 bits of a to-be-compressed number on the data page, and store valid digits of the remaining part in a variable-length manner. However, such a method has a poor compression effect for large numbers.

### SUMMARY

According to a first aspect, an embodiment of the present disclosure provides a data processing method. The method includes: obtaining target compression columns of a plurality of user records on a first data page, where the target compression columns include data of a numeric type; determining a first base value corresponding to each target compression column, where the first base value corresponding to the target compression column is used for base-delta encoding of the target compression columns of respective user records on the first data page; and generating a first base value record based on first base values corresponding to respective target compression columns, and storing the first base value record into the first data page.

In some embodiments, the generating a first base value record based on first base values corresponding to respective target compression columns includes: releasing storage space occupied by an invalid user record on the first data page if remaining storage space of the first data page is smaller than storage space occupied by a next user record to be inserted into the first data page, and determining compression rates of valid user records in the plurality of user records in the process of releasing the storage space; and compressing, if the compression rates of the valid user records satisfy a preset first compression rate condition, the target compression columns corresponding to the valid user records based on the first base values corresponding to the respective target compression columns, and generating the first base value record based on the first base values corresponding to the respective target compression columns.

In some embodiments, the method further includes: migrating a target user record in the plurality of user records to a second data page if the remaining storage space of the first data page is still smaller than the storage space occupied by the next user record to be inserted into the first data page after the storage space occupied by the invalid user record on the first data page is released.

In some embodiments, the migrating a target user record in the plurality of user records to a second data page includes: migrating the target user record in an uncompressed state to the second data page if a compression rate of the target user record does not satisfy a preset second compression rate condition; and/or migrating the target user record in a compressed state to the second data page if the compression rate of the target user record satisfies the preset second compression rate condition, and storing a second base value record into the second data page, where the second base value record includes a second base value corresponding to each target compression column, and the second base value corresponding to the target compression column is used for compressing the target compression column of the target user record.

In some embodiments, the migrating the target user record in a compressed state to the second data page includes: decompressing the target user record based on the first base value record if the target user record is a compressed user record on the first data page; and migrating a decompressed target user record to the second data page.

In some embodiments, the method further includes: recording a first flag bit on the first data page after the first base value record is generated based on the first base values corresponding to the respective target compression columns, where the first flag bit is used for representing that the first data page includes the first base value record; and/or recording a second flag bit in a user record after a target compression column of the user record on the first data page is compressed, where the second flag bit is used for representing that the user record is a compressed user record.

In some embodiments, the generating a first base value record based on first base values corresponding to respective target compression columns includes: generating a compression entry corresponding to each target compression column, where the compression entry corresponding to the target compression column includes identification information of the target compression column and a base value of the target compression column; and encapsulating a quantity of the target compression columns on the first data page and compression entries corresponding to the respective target compression columns into the first base value record.

In some embodiments, the first base value record further includes at least one of the following information: a version number of a compression algorithm; and check information used for checking the first base value record.

In some embodiments, after the storing the first base value record into the first data page, the method further includes: compressing, based on the first base value record, a new user record to be inserted into the first data page; and inserting a compressed new user record into the first data page; and/or decompressing a to-be-updated user record on the first data page based on the first base value record; and compressing an updated user record based on the first base value record after a decompressed to-be-updated user record is updated.

In some embodiments, a numeric relationship after numbers of the target compression columns of the plurality of user records are compressed is the same as a numeric relationship before the numbers are compressed; and the method further includes: obtaining to-be-queried data after the base-delta encoding of the target compression columns of the plurality of user records on the first data page is performed; compressing the to-be-queried data based on a first base value corresponding to a target compression column to which the to-be-queried data belongs; and determining a target user record from a plurality of compressed user records based on compressed to-be-queried data.

In some embodiments, the method further includes: decompressing respective target compression columns of compressed user records based on the first base value record.

According to a second aspect, an embodiment of the present disclosure provides a data processing apparatus. The apparatus includes: an obtaining module, configured to obtain target compression columns of a plurality of user records on a first data page, where the target compression column includes data of a numeric type; a determining module, configured to determine a first base value corresponding to each target compression column, where the first base value corresponding to the target compression column is used for base-delta encoding of the target compression columns of respective user records on the first data page; and a generation module, configured to generate a first base value record based on first base values corresponding to respective target compression columns, and store the first base value record into the first data page.

According to a third aspect, an embodiment of the present disclosure provides a computer-readable medium, having a computer program stored therein, where the program, when executed by a processor, implements the method provided in any one of embodiments of the present disclosure.

According to a fourth aspect, an embodiment of the present disclosure provides a computer device, including a memory, a processor, and a computer program stored on the memory and executable by the processor, where the processor, when executing the program, implements the method provided in any one of embodiments of the present disclosure.

In the embodiments of the present disclosure, a first base value of each target compression column is obtained, and base-delta encoding of a target compression column of each user record on a first data page is performed based on the first base value. In this way, because data in a same target compression column has a same attribute, the data usually has a similar data distribution feature, and a first base value can usually be determined for the data in the same target compression column. In addition, a to-be-encoded number in the target compression column is converted to a difference between the number and the base value by using the first base value, the difference is usually less than the original value, and more high-order 0 bits can be removed. Therefore, a large number is converted to a smaller number, thereby improving the compression rate. In addition, the base value is recorded in a first base value record, and the first base value record is stored into the first data page. Therefore, during decompression, the first base value record can be directly read from the first data page to decompress respective compressed target compression columns.

It should be understood that, the foregoing general descriptions and the following detailed descriptions are only for exemplary and explanatory purposes, but not for limiting the present disclosure.

### BRIEF DESCRIPTION OF DRAWINGS

The accompanying drawings herein are incorporated into this specification and constitute a part of the present disclosure, illustrate embodiments of the present disclosure, and are used to explain the technical solutions of the present disclosure together with this specification.
FIG. 1 is a flowchart of a data processing method according to an embodiment of the present disclosure.
FIG. 2 is a schematic diagram of user records on a first data page.
FIG. 3 is a schematic diagram of user records after base-delta encoding.
FIG. 4 is a schematic diagram of a specific structure of a first data page before and after compression according to an embodiment of the present disclosure.
FIG. 5 is a flowchart of a compression process according to an embodiment of the present disclosure.
FIG. 6 is a flowchart of a decompression process according to an embodiment of the present disclosure.
FIG. 7 is a schematic diagram of a data processing apparatus according to an embodiment of the present disclosure.
FIG. 8 is a schematic diagram of a computer device according to an embodiment of the present disclosure.

### DESCRIPTION OF EMBODIMENTS

Exemplary embodiments are described in detail herein, and examples of the exemplary embodiments are shown in the accompanying drawings. When the following descriptions are made with reference to the accompanying drawings, unless otherwise indicated, the same numbers in different accompanying drawings indicate the same or similar elements. The following implementations described in the following exemplary embodiments do not represent all implementations that are consistent with the present disclosure. Instead, they are only examples of the apparatus and method according to some aspects of the present disclosure as recited in the appended claims.

The terms used in the present disclosure are only for the purpose of illustrating specific embodiments, and are not intended to limit the present disclosure. The terms "a", "said", and "the" of singular forms used in the present disclosure and the appended claims are also intended to include plural forms, unless otherwise specified in the context clearly. It should also be understood that, the term "and/or" used in this specification indicates and includes any or all possible combinations of one or more associated listed items. In addition, the term "at least one" in this specification indicates any one of a plurality or any combination of at least two of the plurality.

It should be understood that, although the terms "first", "second", and "third" may be used in the present disclosure to describe various pieces of information, these pieces of information are not limited by the terms. The terms are only used to differentiate the same type of information. For example, without departing from the scope of the present disclosure, first information may also be referred to as second information, and similarly, second information may also be referred to as first information. Depending on the context, for example, a word "if' used herein may be explained as "while ..." or "when ..." or "in response to determining".

To make a person skilled in the art better understand the technical solutions in the embodiments of the present disclosure, and make the objectives, features, and advantages of the embodiments of the present disclosure more apparent and comprehensible, the technical solutions in the embodiments of the present disclosure are further described in detail below with reference to the accompanying drawings.

As basic software of data storage, databases have been widely applied to many industries. With popularization of the Internet and application of various new technologies, generated service data is increasing, and data stored into databases is also increasing. A database generally uses a fixed-size data page as a smallest storage unit, and common data organization manners include a heap-organized table and an index-organized table. Data compression based on the data page can reduce storage overheads and improve performance of a data system.

In data types supported by a database system, a numeric type is widely used, and compression of data of the type can effectively reduce storage space. In some compression solutions, during storage of a number, high-order 0 bits are first removed, and only a valid part of low-order bits is stored. In this way, a storage manner of the number is changed from fixed-length storage to variable-length storage, and space actually occupied by the number is determined by a value of the number. However, such a compression method has a non-ideal number compression effect for large numbers.

By using an integer number as an example, before compression, a number is represented by fixedly using four bytes. For example, a decimal number 1 before compression may be represented as: 0000 0000 0000 0000 0000 0000 0000 0001; and a decimal number 2147483647 before compression may be represented as: 1111 1111 1111 1111 1111 1111 1111 1111. It can be seen that, regardless of whether the stored number is 1 or the maximum value 2147483647, four bytes are occupied (when the quantity of occupied bytes is less than four, padding 0 in a high order is performed), causing waste of storage space. For this case, in some compression solutions, high-order 0 bits of a to-be-compressed number is removed, and valid digits of the remaining part are stored in a variable-length manner of header+payload, where the header occupies one byte, and a quantity of bytes occupied by the valid digits of the remaining part is stored. According to this method, after 0 in high-order three bytes of the decimal number 1 is removed, the remaining valid bit is one (represented as 0000 0001 in binary) byte, which may be represented as 0000 0001 0000 0001, and occupies two bytes in total; and no high-order 0 bits can be removed from the decimal number 2147483647, and the remaining valid bit is still four (represented as 0000 0100 in binary) bytes, which may be represented as 0000 0100 1111 1111 1111 1111 1111 1111 1111 1111, and occupies five bytes in total. Apparently, this method is very effective if a number is small, but this method has a non-ideal compression effect for a large number. In addition, numbers compressed in the compression manner can be compared only after being first decompressed, and direct comparison of the compressed numbers and more efficient comparison of the compressed numbers in bytes are not supported.

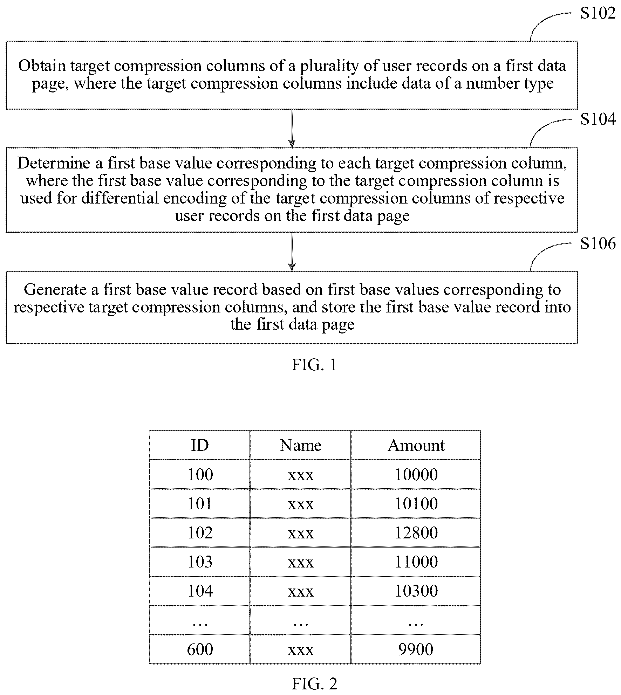

Based on this, an embodiment of the present disclosure provides a data processing method. Referring to FIG. 1, the method includes the following steps.

Step S102: Obtain target compression columns of a plurality of user records on a first data page, where the target compression columns include numbers.

Step S104: Determine a first base value corresponding to each target compression column, where the first base value corresponding to the target compression column is used for base-delta encoding of the target compression columns of respective user records on the first data page.

Step S106: Generate a first base value record based on first base values corresponding to respective target compression columns, and store the first base value record into the first data page.

In step S102, the first data page may be a fixed-size (for example, 16 K) data page in a database. The first data page may include the plurality of user records, for example, a record used for storing user identity information, a record used for storing user transaction information, and a record used for storing a user credit. This is not limited in the present disclosure. Each user record may include one or more same columns. For example, in the record used for storing the user identity information, each user record may include columns such as an ID, a name, an age, a gender, and an identity card number of a user. In the record used for storing the user transaction information, each user record may include columns such as a user ID, transaction time, and a transaction amount. In the record used for storing the user credit score, each user record may include columns such as a student ID of a user, a name of a selected course, and a score of the selected course.

The target compression columns may be selected from respective columns included on the first data page. The target compression columns are columns including numbers. The numbers may be data such as the user ID and the transaction amount. For example, in some application scenarios, a user record on the first data page may be the record used for storing the user identity information, and an identity card in the user record may include a number, or may include a letter (for example, X). Information about all columns on the first data page may be traversed, and it is determined, according to a type of each column, whether the column is a target compression column. In this case, if a column of data includes a number, the column is a target compression column. Otherwise, the column is not a target compression column. Further, when a storage length of a number is greater than a preset length threshold (for example, three bytes), a compression effect is relatively good. Therefore, it may also be determined, based on a type of each column of data and a storage length of the column of data, whether the column is a target compression column. In this case, if a column of data includes a number and a storage length of the number in the column is greater than the preset length threshold, the column is a target compression column. As long as any one of the two conditions: the data type and the storage length, is not satisfied, the column is not a target compression column.

A quantity of the target compression columns on the first data page may be greater than or equal to 1, and when the quantity of target compression columns is greater than 1, each target compression column on the first data page may be obtained. An example in which a user record on the first data page is a record used for storing user transaction information is used. A column corresponding to a user ID and a column corresponding to a transaction amount may both be target compression columns. Therefore, the two target compression columns may be separately obtained from the first data page.

In step S104, the first base value (base) corresponding to each target compression column may be determined. A first base value corresponding to a target compression column is used for subtracting a number included in the target compression column from the base value, to obtain a difference (delta). The difference is usually less than an original value. In this way, a large number is converted to a small number, thereby reducing storage space.

A plurality of strategies for selecting the first base value are provided. The first base value may be a minimum value, an average value, a middle value, or the like of the target compression columns of respective user records on the first data page. When the quantity of target compression columns is greater than 1, the first base values corresponding to the target compression columns may be selected by using a same strategy or different strategies. All the user records on the first data page may be traversed, and data of the target compression columns is extracted from the user records for aggregation and calculation, to determine data distribution features of the data of the target compression columns, and determine the first base values based on the data distribution features. For example, when a minimum value is used as a first base value, all data (numbers) of a same target compression column may be compared, and a minimum number in the target compression column is used as the first base value. When an average value is used as a first base value, a SUM operation may be performed on all data (numbers) of a same target compression column, and a SUM result is divided by a quantity of the numbers in the target compression column, to obtain the first base value. When a middle value is used as a first base value, all data (numbers) of a same target compression column may be sorted. If numbers with an odd quantity exist, an ((n+1)/2)^{th} number in a sorting result is selected as the first base value; and if numbers with an even quantity exist, an (n/2)^{th} number in the sorting result is selected as the first base value.

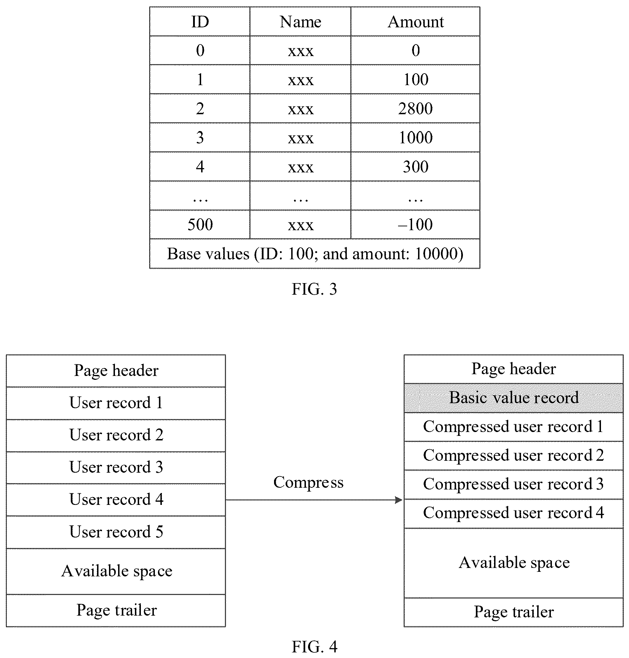

FIG. 2 shows user records used for storing user transaction information. The user records are user records before compression, and include three columns of data, namely, a user ID, a name, and an amount. The column in which the ID is located and the column in which the amount is located are target compression columns. By using the column in which the ID is located as an example, when a minimum value is used as a first base value, a first base value corresponding to the column in which the ID is located is 100. When an average value is used as a first base value, the first base value corresponding to the column in which the ID is located is 350 (that is, an average value of 100, 101, ..., and 600). When a middle value is used as a first base value, the first base value corresponding to the column in which the ID is located is 350. By using an example in which the minimum value is used as the first base value, FIG. 3 shows differences obtained by subtracting corresponding base values from data in target compression columns. It can be seen that, after the first base values are subtracted, differences corresponding to target compression columns in most data records are less than the original values, so that space actually required for storing the numbers can be reduced.

In step S106, first base values corresponding to all selected target compression columns may be stored into the first base value record. Specifically, a compression entry corresponding to each target compression column may be generated, where the compression entry corresponding to each target compression column includes identification information of the target compression column (for example, a column number of the target compression column) and a base value of the target compression column. Then, the quantity of the target compression columns on the first data page and compression entries corresponding to the respective target compression columns may be encapsulated into the first base value record. Assuming that identification information of an i^{th} target compression column is denoted as col no_i and a base value of the target compression column is denoted as base_i, compression entries <col no_1, base_1>, <col no_2, base_2>, ..., and <col no_m, base_m> corresponding to target compression columns may be obtained and encapsulated into the first base value record. In the foregoing user records used for storing the user transaction information, the column in which the ID is located and the column in which the amount is located are both the target compression columns; and when the minimum value is used as the first base value, the first base value corresponding to the column in which the ID is located is 100, and the first base value corresponding to the column in which the amount is located is 10000. Therefore, two compression entries: <col no_1=1, base_1=100> and <col no_2=3, base_2=10000> may be encapsulated into the first base value record.

It should be noted that, in some cases, not every column on the first data page is a target compression column. For example, in the embodiments shown in FIG. 2 and FIG. 3, the column corresponding to the name is not a target compression column. Therefore, the column corresponding to the name does not include a compression entry, which indicates that data of the column does not need to participate in compression of the first data page.

In a more specific embodiment, the first base value record may include the following information:
A version number (Version) of a compression algorithm. The information may be represented by using data of one byte. The compression algorithm may include base-delta encoding, and may also include another algorithm. For example, the target compression column of each user record may be compressed through base-delta encoding, and then a difference obtained through base-delta encoding is compressed by using another encoding method. Therefore, the version number of the compression algorithm may be a version number of a whole set of compression algorithms including the base-delta encoding and the another algorithm.

Check information (Magic number) used for checking the first base value record. The information may be represented by using data of one byte.

A quantity of compression entries (# columns) used for recording a quantity of pieces of <col no, base> included in the first base value record. The information may be represented by using data of two bytes, so that first base values corresponding to 65536 target compression columns can be saved in the first base value record at most.

A compression entry <col no, base> includes identification information of a target compression column and a first base value corresponding to the target compression column, and may be stored in a compact manner. A length of the compression entry depends on a size of the first base value.

It may be understood that, the foregoing embodiment is only an exemplary description. In an actual application, the first base value record may include only part of the foregoing information. For example, the first base value record includes only the compression entries corresponding to the respective target compression columns and the quantity of the compression entries; or includes only the compression entries corresponding to the respective target compression columns, the quantity of the compression entries, and the version number of the compression algorithm; or includes only the compression entries corresponding to the respective target compression columns, the quantity of the compression entries, and the check information. In addition, the quantities of bytes used by the foregoing various pieces of information may be set to other values according to requirements.

A total length of the first base value record is variable, and the length thereof depends on a quantity of target compression columns participating in compression and base values corresponding to the target compression columns. Different data pages may have first base value records of different lengths. During construction of the first base value record, all user records on a current data page may be traversed, a data distribution feature of each target compression column is analyzed, and an appropriate value is finally selected as a first base value according to the data distribution feature.

An embodiment of a specific process of generating the first base value record is described below by using an example.

In some embodiments, during initial insertion of a user record into the first data page or initial modification of a user record, data compression may not be performed on the user record. "Initial" may mean that before the first data page is full in storage for the first time (in other words, remaining storage space of the first data page is insufficient for storing a new user record), or before a quantity of user records on the first data page reaches a preset quantity threshold. When the quantity of data records on the first data page is relatively small, it is usually difficult to accurately determine the data distribution features of the target compression columns. In this way, it is difficult to select appropriate first base values to compress data in the target compression columns. Therefore, the initially inserted or modified user record is not compressed, so that the case in which the selected first base values are inappropriate because it is difficult to determine the data distribution features can be reduced.

When the remaining storage space of the first data page is smaller than storage space occupied by a next user record to be inserted into the first data page, data page organization (page reorganize) or data page splitting (page split) may be performed on the first data page, to attempt to vacate sufficient continuous vacant storage space on the first data page. In the foregoing process, the first base value record may be generated, and the user records may be compressed.

Two operations are mainly involved herein. First, an attempt is made to perform data page organization on the first data page, to be specific, storage space occupied by an invalid user record on the first data page is released. The invalid user record may be a user record that has been deleted. After the storage space occupied by the invalid user record is released, an attempt may be made to compress valid user records on the first data page (that is, remaining user records on the first data page). If compression rates of the valid user records satisfy a preset first compression rate condition, the target compression columns corresponding to the valid user records are compressed based on the first base values corresponding to the respective target compression columns respectively, and the first base value record is generated based on the first base values corresponding to the respective target compression columns.

The first compression rate condition is used for representing whether the valid user records on the first data page are suitable for compression, that is, whether storage space occupied by the valid user records on the first data page after compression can be effectively reduced. Optionally, the first compression rate condition may be a total compression rate of respective valid user records, which may be determined based on a ratio of a length of the respective valid user records after compression to a length of the valid user records before compression. If the total compression rate is greater than a preset compression rate threshold, it may be determined that the first compression rate condition is not satisfied. Otherwise, it is determined that the first compression rate condition is satisfied. Alternatively, the first compression rate condition may be a quantity of valid user records whose compression rates are less than the preset compression rate threshold. If the quantity is greater than a preset quantity threshold, it may be determined that the first compression rate condition is satisfied. Otherwise, it is determined that the first compression rate condition is not satisfied. The first compression rate condition may alternatively be another condition, which is not listed one by one herein.

When an attempt is made to compress the valid user records on the first data page, a temporary data page may be generated, the target compression columns corresponding to the user records on the first data page may be compressed based on the first base values corresponding to the respective target compression columns, and then compressed user records may be written into the temporary data page. Then, it is determined whether respective compressed user records on the temporary data page satisfy the first compression rate condition. If the compressed user records on the temporary data page satisfy the first compression rate condition, the user records before compression may be deleted from the first data page, and the compressed user records on the temporary data page may be written into the first data page. If the first compression rate condition is not satisfied, the temporary data page may be directly deleted, and the uncompressed user records are still stored into the first data page. For example, some numbers (for example, 100000, 100000, 200000, and 300000) at relatively large intervals are not suitable for compression, and generally do not satisfy the first compression rate condition. If numbers included in the target compression column have the feature, compression may not be performed, and uncompressed user records are directly stored into the first data page.

After the storage space occupied by the invalid user record on the first data page is released, if the remaining storage space of the first data page is still smaller than the storage space occupied by the next user record to be inserted into the first data page, data page splitting may be performed on the first data page, to be specific, a target user record in the plurality of user records may be migrated to a second data page. The target user record may include some user records on the first data page. The target user record may be selected in a plurality of manners. For example, a preset quantity of user records on the first data page may be migrated to the second data page. The preset quantity of user records may be a plurality of consecutive user records on the first data page, a plurality of user records having a similar data distribution feature, or a plurality of user records satisfying another condition.

Because the user records on the first data page may be compressed or may not be compressed, the following cases may occur when the target user record is migrated to the second data page:
(1) If a compression rate of the target user record satisfies a preset second compression rate condition, a compressed target user record may be stored into the second data page. In this case, if target user records on the first data page are not compressed, the uncompressed target user records may be compressed and migrated to the second data page (in other words, the target user record in a compressed state is migrated to the second data page).
(2) If a compression rate of the target user record does not satisfy a preset second compression rate condition, an uncompressed target user record may be stored into the second data page. In this case, if target user records on the first data page are not compressed, the uncompressed target user records may be directly migrated to the second data page without compression (in other words, the target user record in an uncompressed state is migrated to the second data page).
(3) If a compression rate of the target user record satisfies a preset second compression rate condition, a compressed target user record may be stored into the second data page. In this case, if target user records on the first data page are compressed, the compressed target user records may be directly migrated to the second data page, to store the compressed target user records into the second data page (in other words, the target user record in a compressed state is migrated to the second data page).
(4) If a compression rate of the target user record does not satisfy a preset second compression rate condition, an uncompressed target user record may be stored into the second data page. In this case, if target user records on the first data page are compressed, the compressed target user records may be decompressed and migrated to the second data page, to store uncompressed target user records into the second data page (in other words, the target user record in an uncompressed state is migrated to the second data page). Decompression of the target user record may be implemented based on the first base value record.

The second compression rate condition may be the compression rate of the target user record, and the compression rate may be determined based on a ratio of a length of the target user record after compression to a length of the target user record before compression. When a quantity of target user records is greater than 1, it may be determined whether each target user record satisfies the second compression rate condition. If the compression rate of the target user record is less than a threshold (for example, 80%, which may be configured), it may be determined that the second compression rate condition is satisfied. Otherwise, it is determined that the second compression rate condition is not satisfied. A compression operation is data-related, and a data distribution feature directly affects the compression rate. Due to uncertainty of data distribution features of the target compression columns included in the user records, not each user record can obtain an appreciable compression rate after compression. In addition, invalid (to be specific, the second compression rate condition is not satisfied) compression and subsequent decompression operations consume an extra CPU, which needs to be avoided as much as possible. Therefore, in the embodiments of the present disclosure, the second compression rate condition is set when the target user record is compressed. If the second compression rate condition is satisfied, it is considered that the compression is valid, and the compressed target user record may be stored into the second data page. Otherwise, it is considered that the compression is invalid, and the uncompressed target user record may be stored on the second data page.

Therefore, each target user record has flexibility of being separately compressed and being not compressed. In some embodiments, after the target user record is compressed, a second flag bit may be recorded in the target user record, to represent that the target user record is a compressed user record. The second flag bit may be represented by using a one-bit binary number. For example, if a second flag bit in a user record is "1", it indicates that the user record is a compressed user record; and if a second flag bit in a user record is "0", it indicates that the user record is an uncompressed user record. Alternatively, if a second flag bit in a user record is non-null, it indicates that the user record is a compressed user record; and if a second flag bit in a user record is null, it indicates that the user record is an uncompressed user record. In addition to the target user record, each user record on the first data page may also include a second flag bit, to represent whether the user record is a compressed user record.

If the second data page includes a compressed target user record, a second base value record may further be stored into the second data page. The second base value record includes a second base value corresponding to each target compression column. The second base value may be the same as or different from the first base value. It is assumed that user records on the first data page are shown in FIG. 2. During data page splitting, it is assumed that user records with IDs of 300 to 600 are migrated to the second data page as target user records. In this case, for the target compression column in which the ID is located, 300 may be used as the second base value. In other words, the second base value is different from the first base value. It is assumed that user records with IDs of 100 to 299 are migrated to the second data page as target user records. In this case, for the target compression column in which the ID is located, 100 may still be used as the second base value. In other words, the second base value is the same as the first base value.

Information that may be included in the second base value record is the same as that of the first base value record. For example, the information may include the version number of the base-delta encoding algorithm, check information used for checking the second base value record, a quantity of compression entries, and compression entries corresponding to the respective target compression columns. For detailed descriptions of the foregoing information, reference may be made to related descriptions in the first base value record. Details are not described herein again.

After the first base value record is generated, the first base value record may further be stored at a specified location on the first data page (for example, a location before a first user record on the first data page). FIG. 4 shows a layout of a first data page before and after compression. It can be seen that, before compression, the first data page includes only a page header, user records, and a page trailer. After compression, a base value record is newly added to the first data page, the base value record stores a base value (base) used by each compression column, and the information needs to be used during compression and decompression.

In some embodiments, not all first data pages include the first base value record. For example, the first base value record may be constructed and saved on the first data page only when a user record on the first data page is compressed for the first time. After a first base value record is generated for a first data page, a first flag bit may be recorded on the first data page, to represent that the first data page includes the first base value record. For example, the first flag bit may be recorded in a page header of the first data page. If a user record on a first data page does not need to be compressed, the first data page does not include a first base value record. Therefore, the data page has flexibility of being separately compressed and being not compressed. Recording the first flag bit on the first data page may refer to changing the first flag bit on the first data page from an invalid state to a valid state. For example, the first flag bit is represented by using one bit, the first flag bit is in the invalid state when being "0", and the first flag bit is in the valid state when being "1". Therefore, recording the first flag bit on the first data page may refer to changing the first flag bit on the first data page from "0" to "1". Alternatively, recording the first flag bit on the first data page may refer to writing a non-null first flag bit into the first data page when the first flag bit on the first data page is null.

In addition to the foregoing descriptions in which the user records are compressed in batches when the first base value record is generated, when a new user record is to be inserted into the first data page, the new user record to be inserted into the first data page may be compressed based on the first base value record, and a compressed new user record is inserted into the first data page. In addition, when a user record on the first data page is to be updated, the to-be-updated user record on the first data page may be decompressed based on the first base value record, and an updated user record is compressed again based on the first base value record after a decompressed to-be-updated user record is updated.

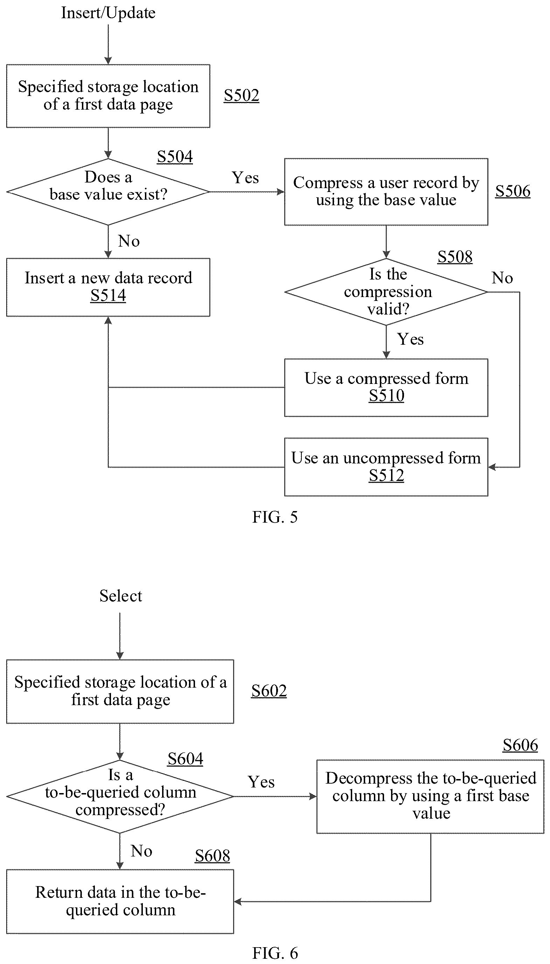

Referring to FIG. 5, when a new user record is to be inserted, a first base value record may be first read from a specified storage location of a first data page (S502). For each column in the new user record, it may be determined whether a first base value corresponding to the column exists in the first base value record (S504). If the first base value corresponding to the column exists, the corresponding column in the to-be-inserted new user record is compressed by using the first base value (S506), and it is determined whether the compression is valid (S508), for example, it is determined whether a second compression rate condition is satisfied. If the compression is valid, a compressed form of the column is used (that is, data of the column is compressed) (S510), and the compressed form of the column is inserted into the first data page (S514). Otherwise, an uncompressed form of the column is used (that is, data of the column is not compressed) (S512), and the uncompressed form of the column is inserted into the first data page (S514). If a first base value corresponding to a column does not exist in the first base value record, it indicates that the column does not need to be compressed, so that data of the column may be directly inserted into the first data page (S514).

After an existing user record on the first data page is updated to obtain an updated user record, for each column in the updated user record, it may also be determined whether a first base value corresponding to the column exists in the first base value record (S504). If the first base value corresponding to the column exists, the corresponding column in the updated user record is compressed by using the first base value (S506), and it is determined whether the compression is valid (S508). If the compression is valid, a compressed form of the column is used (that is, data of the column is compressed) (S510), and the compressed form of the column is inserted into the first data page (S514). Otherwise, an uncompressed form of the column is used (that is, data of the column is not compressed) (S512), and the uncompressed form of the column is inserted into the first data page (S514). If a first base value corresponding to a column does not exist in the first base value record, it indicates that the column does not need to be compressed, so that data of the column may be directly inserted into the first data page (S514).

When a query operation is performed on a user record in the first data page, if the user record has been compressed, the user record needs to be decompressed. A specific process is shown in FIG. 6. For a to-be-queried user record, it may be determined that a first base value record is read from a specified storage location of a first data page (S602), and it is determined whether a to-be-queried column is compressed (S604). If the to-be-queried column is compressed, the to-be-queried column is decompressed by using a first base value corresponding to the to-be-queried column in the first base value record (S606), and decompressed data is returned (S608). Otherwise, data in the to-be-queried column is directly returned (S608).

In some embodiments, after the base-delta encoding of the target compression columns of respective user records on the first data page is performed, respective target compression columns of compressed user records may be further decompressed based on the first base value record. Further, the base-delta encoding may be used for pre-processing the user records on the first data page. Then, values of pre-processed target compression columns may be further encoded again by using another encoding algorithm, and the values are stored in a byte comparative manner after high-order 0 bits of the values are removed. In this case, during decompression, the values of the target compression columns encoded again may be first decoded by using a decoding algorithm corresponding to the another encoding algorithm, and then decoded values are decoded again based on the first base values, to obtain values of uncompressed target compression columns.

The following is an example of the re-encoding manner. A person skilled in the art may understand that, the following is only an optional manner of re-encoding. In another embodiment, re-encoding may alternatively be performed by using another encoding manner, which is not listed one by one herein.

In some embodiments, a quantity of bytes of a payload in the pre-processed target compression column may be determined, where the payload is minimum data that can represent a size of the pre-processed target compression column after high-order 0 bits are removed; a header byte is generated, where the header byte includes at least length data, and the length data is obtained according to the quantity of bytes of the payload; and the generated header byte is combined with the payload of the pre-processed target compression column, and combined data is used as an encoding result of the pre-processed target compression column. Further, the header byte includes at least a symbol bit and the length data, where the symbol bit is used for representing the positive and negative of a to-be-encoded integer.

An example in which the value of the pre-processed target compression column is an integer is used. In this case, the value of the pre-processed target compression column may be referred to as a to-be-encoded integer. The quantity of bytes included in the payload is related to a size of the integer, and a quantity of bytes of a payload of the integer is recorded by adding a header byte. Therefore, when sizes of header bytes of two integers are different, sizes of two pieces of data can be determined by only comparing the sizes of the header bytes of the two numbers. When the sizes of the header bytes of the two integers are the same, payload parts of the two integers need to be further compared, to know the sizes of the two integers. In this way, through the foregoing method, when compression is implemented, it can be ensured that a compressed integer can participate in sorting and can be compared with another compressed integer.

For a compressed encoded value corresponding to a piece of data, a byte that is in the encoded value and that corresponds to a first data bit of the data may be further stored at a first address bit of a storage address, and a byte that is in the encoded value and that corresponds to a second data bit of the data may be further stored at a second address bit of the storage address. The first data bit is higher than the second data bit (in other words, the first data bit is a high-order bit of the data, and the second data bit is a low-order bit of the data), and the first address bit is lower than the second address bit (in other words, the first address bit is a low-order bit of the storage address, and the second address bit is a high-order bit of the storage address). In this way, when two pieces of data are compared, encoded values stored in storage addresses may be directly read in descending order of address bits, and the read encoded values are compared. If encoded values in lower address bits are the same, encoded values in next-lowest address bits are compared, and the rest can be deduced by analogy, until comparison of encoded values in all address bits is completed or address bits with different encoded values are found. If the address bits with different encoded values are found, a larger encoded value in the address bits corresponds to a larger value of data before encoding. This manner is referred to as the byte comparable storage manner.

In the foregoing encoding manner, because a header byte is first compared, the header byte may be stored at a lowest address bit of a storage address. For example, if the header byte occupies one byte, the header byte may be stored at 0^{th} to 7^{th} bits of the storage address. Then, a payload is stored. It is assumed that the payload is a hexadecimal number 0x 04 03 02 01, where "0x" indicates hexadecimal, "04" is a highest byte of the hexadecimal number, and "01" is a lowest byte of the hexadecimal number. In this case, "04", "03", "02", and "01" in 0x 04 03 02 01 may be sequentially stored in 8^{th} to 15^{th} bits, 16^{th} to 23^{rd} bits, 24^{th} to 31^{st} bits, and 32^{nd} to 39^{th} bits of a same storage address.

When number sizes of a number A and a number B (both of which are stored in the foregoing manner) after encoding are compared, 0^{th} to 7^{th} bits in two storage addresses may be first read, to obtain header bytes of the two encoded numbers. If the header byte of the number A is greater than the header byte of the number B, it indicates that a value of the number A after decoding is also greater than a value of the number B after decoding. If the header byte of the number A is equal to the header byte of the number B, a payload of the number A is compared with a payload of the number B. Assuming that the payload of the number A is 0x 04 03 02 01 and the payload of the number B is 0x 05 03 02 00, encoded values may be first read from lowest address bits of the corresponding storage addresses, to respectively obtain "04" and "05". "04" is less than "05", and both "04" and "05" correspond to highest-order bits of the numbers before encoding. Therefore, it may be determined that the highest-order bit of the number A before encoding is less than the highest-order bit of the number B before encoding, so that the sizes of the number A and the number B may be determined without decompressing the encoded values of the number A and the number B. During data querying, data in a plurality of compressed user records may be compared with to-be-queried data based on the feature, to determine a user record that hits the to-be-queried data, so that respective user records do not need to be decompressed.

In some embodiments, a numeric relationship after numbers of the target compression columns of the plurality of user records on the first data page are compressed is the same as a numeric relationship before the numbers are compressed. The numerical relationship includes greater than, equal to, and less than. For example, for a same target compression column of two user records: a user record A and a user record B, if a value of the target compressed data of the user record A before compression is greater than/equal to/less than a value of the target compressed data of the user record B before compression, a value of the target compressed data of the user record A after compression is also correspondingly greater than/equal to/less than a value of the target compressed data of the user record B after compression.

Therefore, to-be-queried data may be obtained after the base-delta encoding of the target compression columns of the plurality of user records on the first data page is performed; the to-be-queried data is compressed based on a first base value corresponding to a target compression column to which the to-be-queried data belongs; and a target user record is determined from a plurality of compressed user records based on compressed to-be-queried data. In other words, in the embodiments of the present disclosure, respective compressed user records are not first decompressed and then compared with the to-be-queried data, but the to-be-queried data is first compressed and then compared with the compressed user records. Because the numeric relationships before and after data compression are the same, the user record that hits the to-be-queried data may be determined by comparing the compressed data with the compressed user records. In this way, a quantity of times of decompression in a query process is reduced, thereby improving data query efficiency.

For example, for the user records shown in FIG. 2, the respective user records may be first encoded. After encoding, assuming that to-be-queried data is amount data in a user record in which an ID is 200, the first base value corresponding to the column in which the ID is located may be queried from the first base value record, the number "200" is compressed by using the first base value, then the user record in which the ID is 200 is determined based on a value of the number "200" after compression and values of the columns of the user records in which IDs are located after compression, then the first base value corresponding to the column in which the amount is located is queried from the first base value record, the column in which the amount is located in the user record in which the ID is 200 is decompressed by using the first base value, and decompressed amount data is returned. In this way, compression and decompression need to be performed only once in the entire query process.

In addition, this specification further provides an integer decoding method, used for decoding a value of a target compression column encoded again in the foregoing manner. By still using an example in which the value of the target compression column is an integer (referred to as a to-be-decoded integer), the method includes the following steps:
determining, from a header byte of the to-be-decoded integer, a quantity of bytes of a payload of the to-be-decoded integer;
reading the payload based on the determined quantity of bytes of the payload; and
processing the payload based on a preset integer data type, to obtain a decoding result corresponding to the to-be-decoded integer.

After decoding is performed in the foregoing manner, the decoded target compression column may be further decoded again based on a base value on a first data page, to obtain original data of the target compression column.

The embodiments of the present disclosure have the following beneficial effects:
(1) In the embodiments of the present disclosure, compression and decompression are performed by using a data page and a user record as granularities, and pre-processing is performed through base-delta encoding, so that a larger data range can be covered. A base value is selected from all numbers in a same column, and each number is converted to a difference between the number and the base value. The difference is usually less than an original value, and actually requires smaller storage space. In this way, a large number can also be compressed.
(2) Differences are encoded in a byte comparable manner. An important feature of the encoding manner is that encoded data still retains a size relationship of original numbers. In other words, without decompression, sizes of original values of two numbers can be known by directly comparing encoded numbers. This is advantageous in that when an operation such as searching or sorting is performed, overheads caused because a large amount of user records need to be decompressed are avoided, which helps improve system performance.
(3) In the embodiments of the present disclosure, user records are compressed instead of compressing an entire data page. In this way, compression and decompression are directly performed at a database storage layer, so that an entire size of the data page before and after compression can remain unchanged. For example, a data page before and after compression is 16 K. In this way, an operating system does not need to support sparse file and hole punching functions to determine an actual size of each data page after compression; and each data page can also accommodate more user records. Therefore, after a data page of a same size is buffered to a buffer pool, more user records can be read from the data page of the buffer pool, thereby reducing I/O of a magnetic disk, and improving the system performance.
(4) A base value record stores base values of a plurality of target compression columns. Therefore, by reading the base value record, each target compression column in a same user record can be compressed and decompressed. In this way, user records can be read row by row, compressed, and decompressed, thereby reducing a quantity of times of I/O during the compression and decompression.
(5) Only user records suitable for compression are compressed by setting a first compression rate condition and a second compression rate condition, thereby reducing CPU consumption and reducing unnecessary compression.

A person skilled in the art may understand that, in the foregoing method in specific implementations, a writing order of the steps does not imply a strict order of execution and does not impose any limitation on an implementation process, and a specific execution order of the steps should be determined according to functions and possible internal logic of the steps.

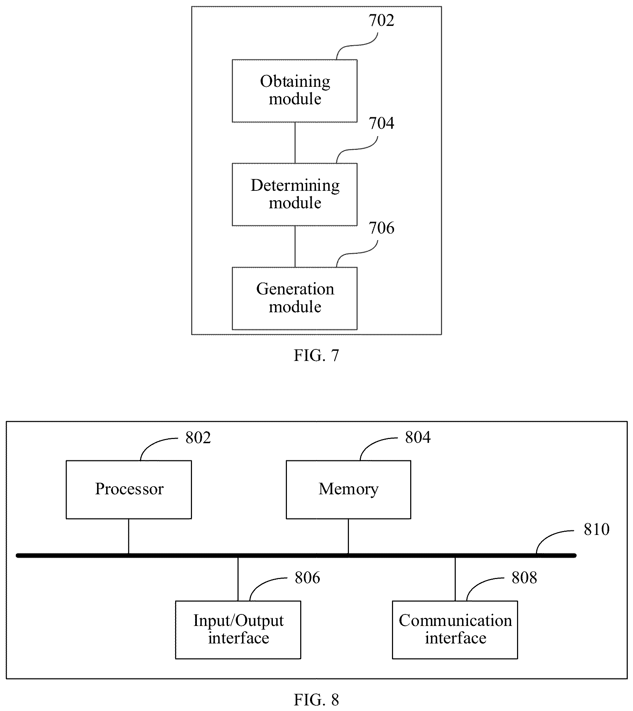

Referring to FIG. 7, an embodiment of the present disclosure further provides a data processing apparatus. The apparatus includes:
an obtaining module 702, configured to obtain target compression columns of a plurality of user records on a first data page, where the target compression columns include data of a numeric type;
a determining module 704, configured to determine a first base value corresponding to each target compression column, where the first base value corresponding to the target compression column is used for base-delta encoding of the target compression columns of respective user records on the first data page; and
a generation module 706, configured to generate a first base value record based on first base values corresponding to respective target compression columns, and store the first base value record into the first data page.

In some embodiments, functions of or modules included in the apparatus provided in this embodiment of the present disclosure may be configured to perform the method described in the foregoing method embodiments. For specific implementation, reference may be made to the descriptions in the foregoing method embodiments. For brevity, details are not described herein again.

An embodiment of the present disclosure further provides a computer device, including at least a memory, a processor, and a computer program stored on the memory and executable by the processor, where the processor, when executing the program, implements the method provided in any one of the foregoing embodiments.

FIG. 8 is a schematic diagram of a more specific hardware structure of a computing device according to an embodiment of the present disclosure. The device may include: a processor 802, a memory 804, an input/output interface 806, a communication interface 808, and a bus 810. The processor 802, the memory 804, the input/output interface 806, and the communication interface 808 are communicatively connected to each other within the device through the bus 810.

The processor 802 may be implemented by a general-purpose central processing unit (CPU), a microprocessor, an application specific integrated circuit (ASIC), one or more integrated circuits, or the like, to execute relevant programs, to implement the technical solutions provided in the embodiments of the present disclosure. The processor 802 may further include a graphics card. The graphics card may be an Nvidia titan X graphics card, a 1080Ti graphics card, or the like.

The memory 804 may be implemented in the form of a read only memory (ROM), a random access memory (RAM), a static storage device, a dynamic storage device, or the like. The memory 804 may store an operating system and other application programs. When the technical solutions provided in the embodiments of the present disclosure are implemented by using software or firmware, related program code is stored in the memory 804, and is invoked and executed by the processor 802.

The input/output interface 806 is configured to connect to an input/output module, to implement input and output of information. The input/output/module may be configured in the device (not shown in the figure) as a component, or may be externally connected to the device to provide a corresponding function. An input device may include a keyboard, a mouse, a touchscreen, a microphone, various sensors, and the like. An output device may include a display, a speaker, a vibrator, an indicator, and the like.

The communication interface 808 is configured to connect to a communication module (not shown in the figure), to implement communication and interaction between the device and another device. The communication module may implement communication in a wired manner (such as a USB or a network cable), or may implement communication in a wireless manner (such as a mobile network, WIFI, or Bluetooth).

The bus 810 includes a path for transmitting information between respective components (for example, the processor 802, the memory 804, the input/output interface 806, and the communication interface 808) of the device.

It should be noted that, although the foregoing device shows only the processor 802, the memory 804, the input/output interface 806, the communication interface 808, and the bus 810, in a specific implementation process, the device may further include another component essential for implementing normal running. In addition, a person skilled in the art may understand that, the foregoing device may alternatively include only components necessary to implement the embodiments of the present disclosure, and does not necessarily include all the components shown in the figure.

An embodiment of the present disclosure further provides a computer-readable medium, having a computer program stored therein, where the program, when executed by a processor, implements the method provided in any one of the foregoing embodiments.

The computer-readable medium includes a non-volatile medium and a volatile medium, a movable medium and a non-movable medium, which may implement storage of information by using any method or technology. The information may be a computer-readable instruction, a data structure, a program module, or other data. Examples of the computer storage medium include, but not limited to: a phase change memory (PRAM), a static random access memory (SRAM), a dynamic random access memory (DRAM), other type of random access memory (RAM), a read only memory (ROM), an electrically erasable programmable read only memory (EEPROM), a flash memory or other memory technology, a compact disc read only memory (CD-ROM), a digital versatile disc (DVD) or other optical storage, a cassette magnetic tape, tape and disk storage or other magnetic storage device or any other non-transmission media that may be configured to store information that a computing device can access. Based on the definitions in this specification, the computer-readable medium does not include transitory computer-readable media (transitory media), such as a modulated data signal and a carrier.

It can be known based on the descriptions of the foregoing implementations that, a person of ordinary skill in the art may clearly understand that the embodiments of the present disclosure may be implemented by software in combination with a necessary universal hardware platform. Based on such an understanding, the technical solutions in the embodiments of the present disclosure essentially or the part contributing to the existing technologies may be implemented in the form of a software product. The computer software product may be stored in a storage medium (for example, a read only memory (ROM)/random access memory (RAM), a magnetic disk or an optical disc), and includes several instructions for instructing a computer device (which may be a personal computer, a server, a network device, or the like) to perform the method described in each or part of the embodiments of the present disclosure.

The system, the apparatus, the module or the unit described in the foregoing embodiments may be specifically implemented by a computer apparatus or an entity, or implemented by a product having a certain function. A typical implementation device is a computer. A specific form of the computer may be a personal computer, a laptop computer, a cellular phone, a camera phone, a smartphone, a personal digital assistant, a media player, a navigation device, an email device, a game console, a tablet computer, a wearable device, or a combination of any of the devices.

The embodiments of the present disclosure are all described in a progressive manner, for same or similar parts in the embodiments, reference is made to these embodiments, and descriptions of each embodiment focus on a difference from other embodiments. Especially, an apparatus embodiment is basically similar to a method embodiment, and therefore is described briefly; for related parts, reference may be made to partial descriptions in the method embodiment. The described apparatus embodiment is only exemplary. The modules described as separate parts may or may not be physically separate. When the solutions in the embodiments of the present disclosure are implemented, functions of the modules may be implemented in a same piece of software and/or hardware or a plurality of pieces of software and/or hardware. Some or all of the modules may alternatively be selected according to actual needs to achieve the objectives of the solutions of the embodiments. A person of ordinary skill in the art may understand and implement the method without any creative effort.

The foregoing descriptions are only exemplary implementations of the embodiments of the present disclosure. A person of ordinary skill in the art may make several improvements or refinements without departing from the principle of the embodiments of the present disclosure and the improvements or refinements shall fall within the protection scope of the embodiments of the present disclosure.

## Claims

1. A data processing method, comprising:
obtaining target compression columns of a plurality of user records on a first data page, wherein the target compression columns comprise data of a numeric type;
determining a first base value corresponding to each target compression column, wherein the first base value corresponding to the target compression column is used for base-delta encoding of the target compression columns of respective user records on the first data page; and
generating a first base value record based on first base values corresponding to respective target compression columns, and storing the first base value record into the first data page.

2. The method according to claim 1, wherein the generating a first base value record based on first base values corresponding to respective target compression columns comprises:
releasing storage space occupied by an invalid user record on the first data page if remaining storage space of the first data page is smaller than storage space occupied by a next user record to be inserted into the first data page, and determining compression rates of valid user records in the plurality of user records in the process of releasing the storage space; and
generating, if the compression rates of the valid user records satisfy a preset first compression rate condition, the first base value record based on the first base values corresponding to the respective target compression columns, and compressing the target compression columns corresponding to the valid user records based on the first base values corresponding to the respective target compression columns.

3. The method according to claim 2, further comprising:
migrating a target user record in the plurality of user records to a second data page if the remaining storage space of the first data page is still smaller than the storage space occupied by the next user record to be inserted into the first data page after the storage space occupied by the invalid user record on the first data page is released.

4. The method according to claim 3, wherein the migrating a target user record in the plurality of user records to a second data page comprises:
migrating the target user record in an uncompressed state to the second data page if a compression rate of the target user record does not satisfy a preset second compression rate condition; and/or
migrating the target user record in a compressed state to the second data page if the compression rate of the target user record satisfies the preset second compression rate condition, and storing a second base value record into the second data page, wherein
the second base value record comprises a second base value corresponding to each target compression column, and the second base value corresponding to the target compression column is used for compressing the target compression column of the target user record.

5. The method according to claim 4, wherein the migrating the target user record in a compressed state to the second data page comprises:
decompressing the target user record based on the first base value record if the target user record is a compressed user record on the first data page; and
migrating a decompressed target user record to the second data page.

6. The method according to claim 1, further comprising:
recording a first flag bit on the first data page after the first base value record is generated based on the first base values corresponding to the respective target compression columns, wherein the first flag bit is used for representing that the first data page comprises the first base value record; and/or
recording a second flag bit in a user record after a target compression column of the user record on the first data page is compressed, wherein the second flag bit is used for representing that the user record is a compressed user record.

7. The method according to claim 1, wherein the generating a first base value record based on first base values corresponding to respective target compression columns comprises:
generating a compression entry corresponding to each target compression column, wherein the compression entry corresponding to the target compression column comprises identification information of the target compression column and a base value of the target compression column; and
encapsulating a quantity of the target compression columns on the first data page and compression entries corresponding to the respective target compression columns into the first base value record.

8. The method according to claim 7, wherein the first base value record further comprises at least one of the following information:
a version number of a compression algorithm; and
check information used for checking the first base value record.

9. The method according to claim 1, wherein after the storing the first base value record into the first data page, the method further comprises:
compressing, based on the first base value record, a new user record to be inserted into the first data page; and
inserting a compressed new user record into the first data page;
and/or
decompressing a to-be-updated user record on the first data page based on the first base value record; and
compressing an updated user record based on the first base value record after a decompressed to-be-updated user record is updated.

10. The method according to claim 1, wherein a numeric relationship after numbers of the target compression columns of the plurality of user records are compressed is the same as a numeric relationship before the numbers are compressed; and the method further comprises:
obtaining to-be-queried data after the base-delta encoding of the target compression columns of the plurality of user records on the first data page is performed;
compressing the to-be-queried data based on a first base value corresponding to a target compression column to which the to-be-queried data belongs; and
determining a target user record from a plurality of compressed user records based on compressed to-be-queried data.

11. The method according to claim 1, further comprising:
decompressing, after the base-delta encoding of the respective target compression columns of the user records on the first data page is performed, respective target compression columns of compressed user records based on the first base value record.

12. A computer-readable storage medium, having a computer program stored therein, wherein the program, when executed by a processor, implements the method according to any one of claims 1 to 11.

13. A computer device, comprising a memory, a processor, and a computer program stored on the memory and executable by the processor, wherein the processor, when executing the program, implements the method according to any one of claims 1 to 11.
